# EUROPÄISCHE PATENTANMELDUNG

(11) **EP 4 586 754 A1**
(43) Veröffentlichungstag der Anmeldung: **16.07.2025**
(21) Anmeldenummer: 24151015.5
(22) Anmeldetag: 09.01.2024
(51) Int. Cl.: H05K 7/20

(54) **MIT ELEKTRONIKBAUTEILEN BESTÜCKTE LEITERPLATTE UND VORRICHTUNG**

(71) Anmelder: VARTA Microbattery GmbH, 73479 Ellwangen Jagst (DE)
(72) Erfinder: Becker, Christian, 86720 Nördlingen (DE); Deschler, Markus, 86643 Rennertshofen (DE); Faass, Andreas, 86756 Reimlingen (DE); Rauwolf, Andreas, 86742 Fremdingen (DE); Wiedeman, Tristan, 86199 Augsburg (DE)
(74) Vertreter: Ostertag & Partner Patentanwälte mbB

(57) **Zusammenfassung**

Es wird eine mit Elektronikbauteilen (10) bestückte Leiterplatte (100) für den Einbau in eine Vorrichtung mit mindestens einem wärmeableitenden Strukturbauteil (200) vorgeschlagen. Die Leiterplatte (100) zeichnet sich dadurch aus, dass wenigstens eines der Elektronikbauteile (10) thermisch leitend mit einer metallischen Flachfeder (50) verbunden ist. Die metallische Flachfeder (50) weist eine mehrfach gebogene Form mit einem ersten Federschenkel und einem zweiten Federschenkel und einem mittleren Federabschnitt auf. Der erste Federschenkel der metallischen Flachfeder (50) ist an der Leiterplatte (100) befestigt. Der mittlere Federabschnitt der metallischen Flachfeder (50) liegt auf dem Elektronikbauteil (10) auf. Der zweite Federschenkel der metallischen Flachfeder (50) liegt frei und ist zur Bildung eines gefederten Kontakts zu dem wärmeableitenden Strukturbauteil (200) der Vorrichtung im montierten Zustand vorgesehen. Vorzugsweise ist zwischen dem mittleren Federabschnitt und dem Elektronikbauteil (10) eine thermisch leitfähige Schicht (60) angeordnet.

## Beschreibung

Die vorliegende Erfindung betrifft eine mit Elektronikbauteilen bestückte Leiterplatte sowie eine Vorrichtung, die wärmeableitende Strukturbauteile, beispielsweise ein metallisches Gehäuse, und mindestens eine solche mit Elektronikbauteilen bestückten Leiterplatte umfasst. Bei dieser Vorrichtung kann es sich insbesondere um einen Akkumulator für ein elektrisches Fahrrad handeln.

### ANWENDUNGSGEBIET UND STAND DER TECHNIK

Fahrräder mit elektromotorischer Unterstützung sind weit verbreitet. Dabei dient der Elektromotor vor allem als Anfahrhilfe und zur Unterstützung der Kurbelbewegung. Es ist aber auch eine vollständige Übernahme des Antriebs durch den Elektromotor möglich. Für die Energieversorgung des Elektromotors wird in der Regel eine Batterie (im Folgenden Fahrradbatterie) verwendet, die eine Mehrzahl von wiederaufladbaren (sekundären) elektrochemischen Energiespeicherelementen, beispielsweise Lithium-Ionen-Zellen, umfasst. Innerhalb der Batterie sind die einzelnen Energiespeicherelemente in der Regel elektrisch miteinander verschaltet. Solche wiederaufladbaren Batterien werden auch als Akkumulatoren bezeichnet.

Fahrradbatterien bzw. Akkumulatoren für Fahrräder umfassen oftmals ein längliches Gehäuse, in dem die Energiespeicherelemente enthalten sind. Das Gehäuse kann beispielsweise von einem metallischen, röhrenartigen Gehäusegrundkörper gebildet sein, der mit stirnseitigen Endkappen verschlossen ist. Die zur elektrischen Kontaktierung der Batterie notwendigen Stecker können bei der Batteriefertigung beispielsweise in eine der Endkappen des Gehäuses eingesetzt sein. Beispielsweise zeigt die DE 10 2021 211 776 B3 einen solchen länglichen Ackumulator, bei dem in eine stirnseitige Endkappe des Gehäuses ein Stecker eingeschraubt ist.

Der Gehäusegrundkörper kann beispielsweise aus Aluminium gefertigt sein, wobei dieses Metall zum einen die ausreichende Stabilität der Batterie sicherstellt und zum anderen für ein verhältnismäßig geringes Gewicht der Batterie sorgt.

Bei den Energiespeicherelementen der Batterie handelt es sich oftmals um Lithium-Ionen-Zellen, die sich durch eine besonders geeignete Energiedichte auszeichnen. Die einzelnen Energiespeicherelemente sind je nach den Anforderungen an den Akkumulator seriell und/oder parallel miteinander verschaltet.

Für den Aufbau einer Batterie beispielsweise für Fahrräder eignen sich sowohl prismatische als auch zylindrische Energiespeicherelemente (zylindrische Rundzellen). Die einzelnen Energiespeicherelemente können beispielsweise aufrechtstehend nebeneinander angeordnet sein. Eine Verschaltung der einzelnen Energiespeicherelemente kann im Bereich der jeweiligen Stirnseiten der Energiespeicherelemente erfolgen.

In die Konstruktion einer modernen Fahrradbatterie oder anderer komplexer Batterien werden in der Regel Leiterplatten (Platinen) integriert. Die Leiterplatten sind üblicherweise mit geeigneten Elektronikbauteilen bestückt, die einen sicheren und kontrollierten Betrieb der Batterie erlauben.

Mittels der Elektronikbauteile kann insbesondere ein Batteriemanagementsystem realisiert werden. Für ein solches Batteriemanagementsystem werden neben Mikroprozessoren in der Regel verschiedene Elektronikbauteile benötigt, um die erforderlichen Mess-, Steuer- und Schutzschaltkreise zu realisieren.

Ein wichtiger Aspekt, der bei dem Betrieb von Batterien, insbesondere bei wiederaufladbaren Batterien, zu beachten ist, ist die Temperierung der Batterie. Im Allgemeinen entsteht sowohl bei der Energieabgabe als auch beim Laden der Energiespeicherelemente Wärme. Eine Überhitzung kann zu Beeinträchtigungen, zu einer Verkürzung der Lebensdauer und zu anderweitigen Schädigungen der Energiespeicherelemente führen. Allerdings kann auch eine zu niedrige Temperatur beispielsweise den Ladevorgang negativ beeinflussen. Für einen sicheren und schonenden Betrieb von Batterien sollte daher ein gewisser Betriebstemperaturbereich eingehalten werden, so dass Maßnahmen zur Temperierung von Batteriemodulen sinnvoll sind.

Neben Kühlmitteln (Luft oder flüssige Kühlmittel) und geeigneten elektronischen Maßnahmen für ein Temperaturmanagement der Batterie sind daher in der Regel auch andere wärmeableitende Maßnahmen vorgesehen.

Eine Wärmeabfuhr bei einer Batterie und insbesondere bei einem Akkumulator kann vor allem über das Gehäuse der Batterie erfolgen, wobei es sich üblicherweise um ein metallisches Gehäuse handelt.

Für eine thermische Anbindung der Elektronikbauteile, die sich auf der oder den Leiterplatten einer Batterie befinden, an das Gehäuse wird oftmals eine thermisch leitfähige Vergussmasse verwendet. Mit der Vergussmasse wird der Abstand zwischen der Leiterplatte mit den Elektronikbauteilen und der Innenseite des Gehäuses ausgefüllt, so dass die Wärme auf das Gehäuse übertragen und nach außen abgegeben werden kann. Alternativ sind gummiartige wärmeableitende Polsterschichten (Wärmeleitpads) bekannt, die auf die bestückte Platine aufgelegt werden und so den Abstand zum Gehäuse überbrücken.

Im Allgemeinen wird mit solchen Maßnahmen eine gute thermische Anbindung der bestückten Leiterplatte an das Gehäuse erreicht. Allerdings sind mit diesen Lösungen verschiedene Nachteile verbunden. Insbesondere werden bei diesen Lösungen zusätzliche Komponenten benötigt, also insbesondere die Vergussmasse oder das Wärmeleitpad, die mit höheren Kosten, einem erhöhten Gewicht der Batterie und einem zusätzlicher Montageaufwand verbunden sind.

Weiterhin bergen diese bekannten Lösungen ein Fehlerpotenzial, da beispielsweise das Wärmeleitpad während der Montage oder im späteren Betrieb verrutschen kann und damit die thermische Anbindung an das Gehäuse unterbrochen wird. Auch das Einbringen der Vergussmasse ist nicht unproblematisch. Es kann beispielsweise vorkommen, dass während der Montage die Vergussmasse die kritischen Elemente der Leiterplatte nicht vollständig erreicht, so dass in einem solchen Fall die thermische Anbindung an das Gehäuse nicht optimal ist.

Darüber hinaus hat insbesondere der Einsatz einer Vergussmasse den Nachteil, dass ein nachträgliches Heraustrennen der Leiterplatte in der Regel nicht mehr möglich ist. Dies ist insbesondere im Hinblick auf eine Reparatur einer Batterie sehr nachteilig.

Die Verwendung eines Wärmeleitpads hat den Nachteil, dass verschieden große Abstände zwischen den Elektronikbauteilen der Leiterplatte und dem Gehäuse in der Regel nicht oder nur unzureichend überbrückbar sind. Gegebenenfalls bleiben Abstände zwischen den Elektronikbauteilen und dem Gehäuse frei, so dass in diesen Bereichen keine thermische Anbindung an das Gehäuse gegeben ist.

### AUFGABE UND LÖSUNG

Vor diesem Hintergrund stellt sich die Erfindung die Aufgabe, die thermische Anbindung von Elektronikbauteilen einer Leiterplatte an wärmeableitende Strukturbauteile einer Vorrichtung zu verbessern. Weiterhin soll eine befriedigende Lösung zur thermischen Anbindung der Elektronikbauteile im Hinblick auf gesetzliche Recycling- und Reparaturvorgaben bereitgestellt werden.

Diese Aufgabe wird durch eine mit Elektronikbauteilen bestückte Leiterplatte gelöst, wie sie sich aus Anspruch 1 ergibt. Bevorzugte Ausgestaltungen dieser bestückten Leiterplatte sind Gegenstand der von Anspruch 1 abhängigen Ansprüche. Weiterhin wird diese Aufgabe durch eine Vorrichtung mit einer solchen bestückten Leiterplatte gemäß dem weiteren nebengeordneten Anspruch und, in bevorzugten Ausgestaltungen, gemäß den von diesem Anspruch abhängigen Ansprüchen gelöst.

Die erfindungsgemäße, mit Elektronikbauteilen bestückte Leiterplatte ist für den Einbau in eine Vorrichtung mit mindestens einem wärmeableitenden Strukturbauteil vorgesehen. Diese Leiterplatte zeichnet sich durch die folgenden Merkmale aus:
a. Wenigstens eines der Elektronikbauteile ist thermisch leitend mit einer metallischen Flachfeder verbunden.
b. Die metallische Flachfeder weist eine mehrfach gebogene Form mit einem ersten Federschenkel und einem zweiten Federschenkel und einem mittleren Federabschnitt auf.
c. Der erste Federschenkel der metallischen Flachfeder ist an der Leiterplatte befestigt.
d. Der mittlere Federabschnitt der metallischen Flachfeder liegt auf dem Elektronikbauteil auf.
e. Der zweite Federschenkel der metallischen Flachfeder liegt frei und ist zur Bildung eines gefederten Kontakts mit dem wärmeableitenden Strukturbauteil der Vorrichtung im montierten Zustand vorgesehen.

Bei dem Strukturbauteil kann es sich insbesondere um ein Gehäuse oder um ein Teil eines Gehäuses handeln. Vorzugsweise handelt es sich um ein metallisches Gehäuse oder um ein metallisches Gehäuseteil.

Mittels der erfindungsgemäß vorgesehen metallische Flachfeder ist es möglich, dass die Elektronikbauteile der Leiterplatte in sehr flexibler Weise thermisch an das Gehäuse oder allgemein an das wärmeableitende Strukturbauteil im montierten Zustand angebunden werden, so dass eine optimale Wärmeabfuhr bei einer Erwärmung der Elektronikbauteile über das wärmeableitende Strukturbauteil, beispielsweise das metallische Gehäuse, nach außen erfolgen kann.

Der besondere Vorteil der erfindungsgemäßen Lösung gegenüber einer herkömmlichen Vergussmasse oder einem vollflächigen Wärmeleitpad liegt vor allem darin, dass die metallische Flachfeder, die zur Wärmeableitung dient, nur an denjenigen Elektronikbauteilen anliegt, an denen eine Wärmeabfuhr wirklich notwendig ist. Durch den freiliegenden Federabschnitt und den dadurch möglichen gefederten Kontakt zu dem wärmeableitenden Strukturbauteil können die vorhandenen Abstände zwischen den Elektronikbauteilen der Leiterplatte und beispielsweise der Innenseite des Gehäuses sehr flexibel überbrückt werden. So ist es möglich, dass auch gewisse Varianzen bei diesen Abständen durch den gefederten Kontakt überbrückt werden, ohne dass weitere Anpassungen der Elektronikbauteile und/oder der metallischen Flachfeder erforderlich wären.

Ein ganz besonderer Vorteil der erfindungsgemäßen Lösung liegt darin, dass sich während der Montage der bestückten Leiterplatte, die bereits vorab mit der oder den metallischen Flachfedern bestückt werden kann, die thermische Anbindung der Elektronikbauteile an das Gehäuse zwangsläufig erfolgt, ohne dass hierfür weitere Maßnahmen zu ergreifen wären. Es entfällt also beispielsweise der zusätzliche Schritt der Applikation einer Vergussmasse oder der Positionierung und Fixierung eines Wärmeleitpads.

Ein weiterer, ganz besonderer Vorteil der erfindungsgemäßen Lösung liegt darin, dass die thermische Anbindung mittels der metallischen Flachfeder reversibel ist. Das heißt, dass der thermische Kontakt zwischen den Elektronikbauteilen und dem wärmeableitenden Strukturbauteil in einfacher Weise wieder getrennt werden kann, da keine feste Fixierung der metallischen Flachfeder an dem Strukturbauteil erforderlich ist. Besonders im Hinblick auf neue Recycling- und Reparaturvorgaben des Gesetzgebers ist es von großer Bedeutung, dass beispielsweise eine Batterie oder eine andere Vorrichtung (Gerät) mit einer solchen Leiterplatte zerstörungsfrei auseinandergebaut werden kann. Bei herkömmlichen Batterien oder anderen Vorrichtungen, bei denen eine Leiterplatte zur thermischen Anbindung mit dem Gehäuse vergossen ist, kann die Leiterplatte nicht zerstörungsfrei ausgebaut werden. Bei der erfindungsgemäßen Lösung hingegen kann die bestückte Leiterplatte mit der oder den metallischen Flachfedern beliebig oft assembliert werden, wobei durch den gefederten Kontakt sich die thermische Anbindung der Elektronikbauteile an das Gehäuse ohne weiteres wiederherstellen lässt.

Durch die federnden Eigenschaften der metallischen Flachfeder sind unterschiedliche Abstände der Elektronikbauteile zum Gehäuse oder einem anderen wärmeableitenden Strukturbauteil problemlos überbrückbar, wobei sich die metallische Flachfeder mehr oder weniger, je nach dem vorhandenen Abstand, verformt.

In einer besonders bevorzugten Ausführungsform der mit Elektronikbauteilen bestückten Leiterplatte ist das folgende zusätzliche Merkmal vorgesehen:
a. Zwischen dem mittleren Federabschnitt und dem Elektronikbauteil ist eine thermisch leitfähige Schicht angeordnet.

Die thermisch leitfähige Schicht sorgt für einen besonders guten Wärmeübergang von dem Elektronikbauteil auf die metallische Flachfeder. Damit wird in der Folge auch der Wärmeübergang an das wärmeableitende Strukturbauteil verbessert.

Weiterhin gewährleistet die thermisch leitfähige Schicht das flächige Aufliegen des mittleren Federabschnitts auf dem Elektronikbauteil. Zudem können durch die thermisch leitfähige Schicht gewisse Unregelmäßigkeiten in der Auflage ausgeglichen werden. Weiterhin kann durch die thermisch leitfähige Schicht auch eine gewisse Polsterung erreicht werden, die im Hinblick auf Erschütterungen oder anderweitige mechanische Belastungen der bestückten Leiterplatte vorteilhaft ist.

Als thermisch leitfähige Schicht kann insbesondere ein an sich bekanntes, dünnes Wärmeleitpad in entsprechender Größe verwendet werden.

Unter einem Wärmeleitpad (Thermal-Pad) ist allgemein eine thermisch leitende Materiallage oder Materialschicht zu verstehen. Üblicherweise werden als Wärmeleitpads flexible und leicht zu verarbeitende flächige Produkte eingesetzt, die im Allgemeinen aus Materialien mit hoher Wärmeleitfähigkeit bestehen und mit oder ohne Trägerschicht angeboten werden. Beispielsweise kann ein Wärmeleitpad aus Silikon bestehen, das mit einem PET-Film verstärkt ist.

In besonders bevorzugten Ausführungsformen ist die thermisch leitfähige Schicht gleichzeitig elektrisch isolierend, so dass Kurzschlüsse mit dem wärmeableitenden Strukturbauteil, beispielsweise dem Gehäuse, sicher vermieden werden.

In besonders bevorzugten Ausführungsformen der mit Elektronikbauteilen bestückten Leiterplatte zeichnet sich die metallische Flachfeder durch mindestens eines der folgenden zusätzlichen Merkmale aus:
a. Die metallische Flachfeder weist mindestens drei, vorzugsweise vier Biegebereiche auf.
b. Sie metallische Flachfeder weist eine Doppel-S-Form auf.

Vorzugsweise sind die vorgenannten Merkmale a. und b. in Kombination miteinander realisiert.

Die Biegebereiche der metallischen Flachfeder sind zweckmäßigerweise so ausgestaltet, dass zum einen die Auflage der Flachfeder auf dem Elektronikbauteil möglich ist und zum anderen der Kontakt mit der Leiterplatte auf der einen Seite und der federnde Kontakt mit dem wärmeableitenden Strukturbauteil in montiertem Zustand möglich ist.

Hierfür eignet sich insbesondere eine Doppel-S-Form der metallischen Flachfeder. Die Doppel-S-Form der metallischen Flachfeder zeichnet sich dabei insbesondere dadurch aus, dass zwei S-förmige Abschnitte durch einen flächigen, mittleren Federabschnitt miteinander verbunden sind. Jeder S-förmige Abschnitt umfasst zwei in entgegengesetzter Richtung gekrümmte Abschnitte, sodass insgesamt vier Biegebereiche vorgesehen sind. Der flächige, mittlere Federabschnitt ist vorzugsweise so ausgebildet, dass er auf dem Elektronikbauteil aufliegen kann.

Vorzugsweise sind die endständigen Abschnitte der metallischen Flachfeder, also der erste Federschenkel und der zweite Federschenkel zumindest zum Teil flächig ausgebildet, sodass eine gute Auflage zum einen an der Leiterplatte und zum anderen an dem Strukturbauteil gewährleistet ist.

In besonders bevorzugten Ausführungsformen ist bei der mit Elektronikbauteilen bestückten Leiterplatte das folgende zusätzliche Merkmal vorgesehen:
a. Der erste Federschenkel ist mit der Leiterplatte verlötet.

Durch das Verlöten des ersten Federschenkels mit der Leiterplatte wird in besonders vorteilhafter Weise eine Fixierung der metallischen Flachfeder an der Leiterplatte erreicht.

Diese Ausführungsform eignet sich insbesondere für eine SMD (Surface Mounted Device)-Bestückung der Leiterplatte, bei der die Elektronikbauteile direkt auf der Leiterplattenoberfläche platziert und gelötet werden. Eine SMD-Bestückung hat den besonderen Vorteil, dass hierdurch eine vollautomatische Fertigung der bestückten Leiterplatte mit den bereits angebrachten metallischen Flachfedern möglich ist.

Ein großer Vorteil ist, dass die Leiterplatte mit den Elektronikbauteilen zusammen mit der ober den metallischen Flachfedern als wärmeableitende Elemente vorab montiert werden können. Dies führt zu einer erheblichen Erleichterung bei der Montage von entsprechenden Vorrichtungen, beispielsweise von Batterien oder anderen Geräten, die mit einer solchen bestückten Leiterplatte ausgestattet werden. Durch die Vorabmontage der metallischen Flachfeder(n) entfällt ein zusätzlicher Schritt für die thermische Anbindung der Elektronikbauteile an beispielsweise das Gehäuse, da sich die thermische Anbindung zwangsläufig durch die federnde Kontaktierung der metallischen Flachfeder(n) an dem Gehäuse nach dem Einsetzen der bestückten Leiterplatte ergibt. Hierdurch werden mögliche Fehlerquellen bei der Montage reduziert.

In besonders bevorzugten Ausführungsformen der mit Elektronikbauteilen bestückten Leiterplatte zeichnet sich die metallische Flachfeder durch mindestens eines der folgenden zusätzlichen Merkmale aus:
a. Die metallische Flachfeder ist eine Stahlfeder.
b. Die metallische Flachfeder weist eine Dicke in einem Bereich von 0,1 bis 1,0 mm auf.

Vorzugsweise sind die vorgenannten Merkmale a. und b. in Kombination miteinander verwirklicht.

Die Ausgestaltung der metallischen Flachfeder als Stahlfeder ist besonders vorteilhaft, da hierdurch zum einen besonders gute wärmeableitende Eigenschaften der metallischen Flachfeder bewirkt werden.

Zum anderen zeichnet sich eine Stahlfeder durch eine besondere gute mechanische Stabilität aus. Insbesondere sind die federnden Eigenschaften einer als Stahlfeder realisierten metallischen Flachfeder derart, dass hierdurch auch eine mehrfache Assemblierung möglich ist, ohne dass die Stahlfeder ihre federnden Eigenschaften verliert.

Die Dicke (Stärke) der metallischen Flachfeder kann je nach Anwendungsbereich der bestückten Leiterplatte ausgestaltet werden. Durch die Dicke der metallischen Flachfeder werden zum einen die mechanischen Eigenschaften der metallischen Flachfeder beeinflusst. Zum anderen wird hierdurch auch die Menge der abführbaren Wärme beeinflusst.

Die Erfindung umfasst weiterhin eine Vorrichtung mit mindestens einem wärmeableitenden Strukturbauteil. Erfindungsgemäß umfasst diese Vorrichtung mindestens eine mit Elektronikbauteilen bestückte Leiterplatte, wobei diese Leiterplatte mit mindestens einer metallischen Flachfeder als wärmeableitendes Element gemäß der obigen Beschreibung ausgestattet ist. Bezüglich weiterer Merkmale dieser Leiterplatte wird auf die obige Beschreibung verwiesen.

Bei dem wärmeableitenden Strukturbauteil kann es sich insbesondere um das Gehäuse oder um zumindest einen Teil des Gehäuses der Vorrichtung handeln, insbesondere ein metallisches Gehäuse oder ein metallisches Gehäuseteil.

In besonders bevorzugten Ausführungsformen der Vorrichtung ist das folgende zusätzliche Merkmal vorgesehen:
a. Die metallische Flachfeder weist eine Längserstreckung auf, die im eingebauten Zustand der Leiterplatte parallel zu einer Längserstreckung des Gehäuses orientiert ist.

Durch diese Ausrichtung der metallischen Flachfeder auf der Leiterplatte ist es ohne weiteres möglich, die bestückte Leiterplatte der Länge nach in ein Gehäuse, beispielsweise in ein röhrenförmiges Gehäuse, einzuschieben. Hierbei erfolgt die flexible Beanspruchung der Metallfeder nur in den Bereichen, die durch die Biegebereiche ohnehin flexibel sind. Auf diese Weise wird ohne weitere Maßnahmen der federnde Kontakt mit der Innenseite des Gehäuses zwangsläufig hergestellt, sodass die thermische Anbindung der Elektronikbauteile an das Gehäuse ohne weitere Maßnahmen realisiert wird.

Die Anordnung der metallischen Flachfeder auf der bestückten Leiterplatte ist weiterhin vorzugsweise so vorgesehen, dass bei einem für die Montage vorgesehenen Einschieben der Leiterplatte der freie Federschenkel nach hinten ausgerichtet ist. Hierdurch wird das Einschieben zum Beispiel in ein röhrenförmiges Gehäuse weiter erleichtert und führt nicht zu einer übermäßigen Belastung der federnden Eigenschaften der metallischen Flachfeder.

Bei der Vorrichtung kann es sich prinzipiell um verschiedene Vorrichtungen (Geräte) handeln, die mit einer bestückten Leiterplatte versehen sind und bei denen eine Wärmeabfuhr von der bestückten Leiterplatte an das Gehäuse oder andere wärmeableitende Strukturbauteile vorgesehen ist.

In besonders bevorzugten Ausführungsformen der Vorrichtung handelt es sich bei der Vorrichtung um eine Batterie, die mit einer Mehrzahl von elektrochemischen Energiespeicherelementen ausgestattet ist. Insbesondere bei Batterien ist eine Wärmeabfuhr nach außen ein wichtiger Aspekt, da sowohl die Entladevorgänge als auch die gegebenenfalls vorgesehenen Ladevorgänge der Batterie (Akkumulator) in der Regel mit einer Wärmeentwicklung einhergehen.

In besonders bevorzugten Ausführungsformen der erfindungsgemäßen Vorrichtung zeichnet sich die Vorrichtung durch das folgende zusätzliche Merkmal aus:
a. Die Vorrichtung ist ein Akkumulator für ein elektrisches Fahrzeug, insbesondere für ein elektrisches Fahrrad.

Insbesondere bei einem Akkumulator für ein elektrisches Fahrzeug, insbesondere bei einem Akkumulator für ein elektrisches Fahrrad, kommen die Vorteile der mit Elektronikbauteilen bestückten Leiterplatte in besonderer Weise zum Tragen. Bei den oftmals in röhrenförmiger Form ausgebildeten Akkumulatoren erleichtert die vorgeschlagene Leiterplatte die Montage erheblich, da die mit den metallischen Flachfedern ausgestattete, mit Elektronikbauteilen bestückte Leiterplatte in einfacher Weise in ein Gehäuse eingeschoben werden kann, so dass sich die thermische Anbindung der Elektronikbauteile an das Gehäuse zwangsläufig einstellt.

Hierdurch werden zum einen zusätzliche Montageschritte für die thermische Anbindung überflüssig. Zum anderen kann das Gewicht der Akkumulatoren im Vergleich mit herkömmlichen Akkumulatoren reduziert werden, da lediglich punktuell an den entsprechenden Stellen metallische Flachfedern auf der Leiterplatte erforderlich sind.

Weiterhin sind Akkumulatoren beispielsweise für elektrische Fahrräder besonderen mechanischen Belastungen ausgesetzt. Dies kann bei herkömmlichen Akkumulatoren mit vollflächigen Wärmeleitpads zu einem Verrutschen des Wärmeleitpads führen, so dass die thermische Anbindung der bestückten Leiterplatte an das Gehäuse oder allgemein an das wärmeableitende Strukturbauteil nicht mehr sicher gewährleistet ist. Dies kann bei der erfindungsgemäßen Lösung durch den federnden Kontakt mit dem wärmeableitenden Strukturbauteil nicht auftreten.

Weitere Vorteile und Merkmale der Erfindung ergeben sich aus der nachfolgenden Beschreibung von Ausführungsbeispielen in Verbindung mit den Zeichnungen. Hierbei können die einzelnen Merkmale jeweils für sich oder in Kombination miteinander verwirklicht sein.

### KURZE BESCHREIBUNG DER ZEICHNUNGEN

In den Zeichnungen zeigen:
- Fig. 1: Schematische Seitenansicht einer mit einem Elektronikbauteil bestückten Leiterplatte mit metallischer Flachfeder und wärmeableitendem Gehäusestrukturbauteil; und
- Fig. 2: seitliche Aufsicht auf eine mit einem Elektronikbauteil bestückte Leiterplatte mit metallischer Flachfeder.

### BESCHREIBUNG VON AUSFÜHRUNGSBEISPIELEN

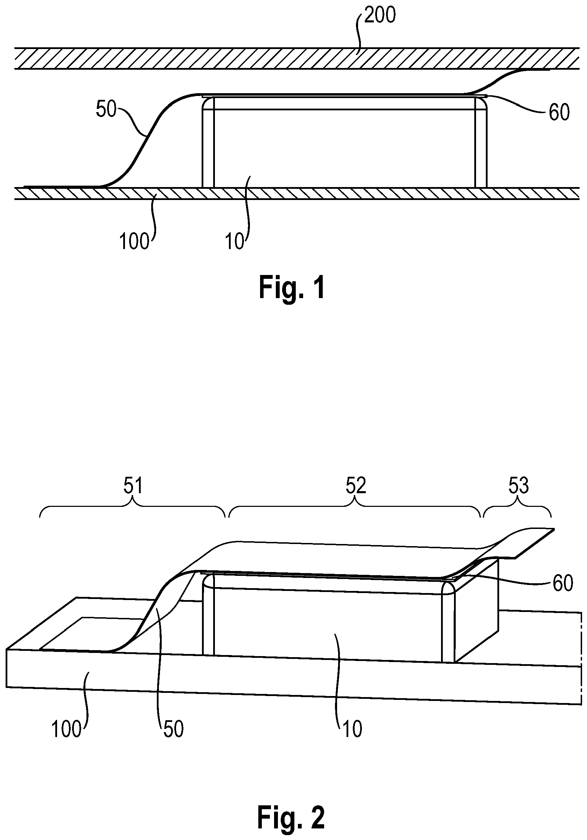

**Fig. 1** zeigt in schematischer Weise eine Seitenansicht einer mit einem Elektronikbauteil 10 bestückten Leiterplatte 100. Das Elektronikbauteil 10 ist über eine metallische Flachfeder 50 an ein Strukturbauteil 200 eines Gehäuses, insbesondere eines metallischen Gehäuses, thermisch angebunden. Zwischen dem Elektronikbauteil 10 und einem mittleren Abschnitt der metallischen Flachfeder 50, welcher auf dem Elektronikbauteil 10 aufliegt, befindet sich eine dünne, thermisch leitfähige Schicht 60, insbesondere ein Wärmeleitpad.

**Fig. 2** zeigt die mit dem Elektronikbauteil 10 bestückte Leiterplatte 100 mit der metallischen Flachfeder 50 und der thermisch leitfähigen Schicht 60 in einer seitlichen Schrägansicht ohne das Strukturbauteil des Gehäuses. Die metallische Flachfeder 50 weist eine Doppel-S-Form mit vier Biegebereichen auf. Die Flachfeder 50 untergliedert sich dabei in drei Abschnitte. Der erste Abschnitt bildet einen ersten Federschenkel 51. Der dritte Abschnitt bildet einen zweiten Federschenkel 53. Der mittlere Abschnitt bildet den mittleren Federabschnitt 52 und weist eine flächige Erstreckung auf. Der mittlere Federabschnitt 52 liegt auf dem Elektronikbauteil 10 auf. Die thermisch leitfähige Schicht 60 befindet sich zwischen dem mittleren Federabschnitts 52 und dem Elektronikbauteil 10.

Die S-förmige Biegung des ersten Federschenkels 51 ist so ausgebildet, dass der endständige Abschnitt des ersten Federschenkels 51 eine flächige Erstreckung aufweist, über die die metallische Flachfeder 50 an der Leiterplatte 100 befestigt und vorzugsweise verlötet ist. Der zweite Federschenkel 53 ist ebenfalls S-förmig gebogen. Dieser zweite Federschenkel 53 liegt frei und bildet im montierten Zustand den gefederten Kontakt zu dem wärmeableitenden Strukturbauteil 200. Auch der endständige Abschnitt des zweiten Federschenkel 53 weist vorzugsweise eine flächige Erstreckung auf, um eine ausreichend große Kontaktfläche mit dem wärmeableitenden Strukturelement 200 bereitzustellen.

Die mit einer oder mehreren metallischen Flachfedern 50 ausgestattete, mit Elektronikbauteilen 10 bestückte Leiterplatte 100 kann für verschiedenartige Vorrichtungen (Geräte) eingesetzt werden. In besonderer Weise eignet sich die Leiterplatte 100 für die Verwendung in Batterien und insbesondere in Akkumulatoren. Beispielsweise kann die Leiterplatte 100 in Akkumulatoren für Fahrräder eingesetzt werden, die mit einer Mehrzahl von zylindrischen Rundzellen oder prismatischen Zellen ausgestattet sind. Beispielsweise kann dabei die Leiterplatte für eine Verschaltung der einzelnen Energiespeicherelemente und/oder für ein Batteriemanagementsystem genutzt werden. In diesem Fall können gemäß den Darstellungen in Fig. 1 und Fig. 2 beispielsweise die einzelnen Energiespeicherelemente unterhalb der Leiterplatte 100 angeordnet sein. Im Fall von zylindrischen Rundzellen können die Rundzellen mit paralleler Ausrichtung ihrer jeweiligen Längsachsen stehend nebeneinander in einer oder mehreren Reihen angeordnet sind und beispielsweise von einem ein- oder mehrteiligen Zellhalter aus Kunststoff gehalten werden.

## Patentansprüche

1. Mit Elektronikbauteilen (10) bestückte Leiterplatte (100) für den Einbau in eine Vorrichtung mit mindestens einem wärmeableitenden Strukturbauteil (200), **gekennzeichnet durch** die folgenden Merkmale:
a. Wenigstens eines der Elektronikbauteile (10) ist thermisch leitend mit einer metallischen Flachfeder (50) verbunden, und
b. die metallische Flachfeder (50) weist eine mehrfach gebogene Form mit einem ersten Federschenkel (51) und einem zweiten Federschenkel (53) und einem mittleren Federabschnitt (52) auf, und
c. der erste Federschenkel (51) der metallischen Flachfeder (50) ist an der Leiterplatte (100) befestigt, und
d. der mittlere Federabschnitt (52) der metallischen Flachfeder (50) liegt auf dem Elektronikbauteil (10) auf, und
e. der zweite Federschenkel (53) der metallischen Flachfeder (50) liegt frei und ist zur Bildung eines gefederten Kontakts mit dem wärmeableitenden Strukturbauteil (200) der Vorrichtung im montierten Zustand vorgesehen.

2. Mit Elektronikbauteilen bestückte Leiterplatte nach Anspruch 1 mit dem folgenden zusätzlichen Merkmal:
a. Zwischen dem mittleren Federabschnitt (52) und dem Elektronikbauteil (10) ist eine thermisch leitfähige Schicht (60) angeordnet.

3. Mit Elektronikbauteilen bestückte Leiterplatte nach Anspruch 2 mit dem folgenden zusätzlichen Merkmal:
a. Die thermisch leitfähige Schicht (60) ist elektrisch isolierend.

4. Mit Elektronikbauteilen bestückte Leiterplatte nach einem der vorhergehenden Ansprüche mit mindestens einem der folgenden zusätzlichen Merkmale:
a. Die metallische Flachfeder (50) weist mindestens drei, vorzugsweise vier Biegebereiche auf,
b. die metallische Flachfeder (50) weist eine Doppel-S-Form auf.

5. Mit Elektronikbauteilen bestückte Leiterplatte nach einem der vorhergehenden Ansprüche mit dem folgenden zusätzlichen Merkmal:
a. Der erste Federschenkel (51) ist mit der Leiterplatte (100) verlötet.

6. Mit Elektronikbauteilen bestückte Leiterplatte nach einem der vorhergehenden Ansprüche mit mindestens einem der folgenden zusätzlichen Merkmale:
a. Die metallische Flachfeder (50) ist eine Stahlfeder,
b. die metallische Flachfeder (50) weist eine Dicke in einem Bereich von 0,1 bis 1,0 mm auf.

7. Vorrichtung mit mindestens einem wärmeableitenden Strukturbauteil (200) und mit mindestens einer mit Elektronikbauteilen (10) bestückten Leiterplatte (100) gemäß einem der Ansprüche 1 bis 6.

8. Vorrichtung nach Anspruch 7 mit dem folgenden zusätzlichen Merkmal:
a. Das wärmeableitende Strukturbauteil (200) bildet zumindest einen Teil eines Gehäuses der Vorrichtung.

9. Vorrichtung nach Anspruch 8 mit dem folgenden zusätzlichen Merkmal:
a. Die metallische Flachfeder (50) weist eine Längserstreckung auf, die im eingebauten Zustand der Leiterplatte (100) parallel zu einer Längserstreckung des Gehäuses orientiert ist.

10. Vorrichtung nach einem der Ansprüche 7 bis 9 mit dem folgenden zusätzlichen Merkmal:
a. Die Vorrichtung ist eine Batterie mit einer Mehrzahl von elektrochemischen Energiespeicherelementen.

11. Vorrichtung nach einem der Ansprüche 7 bis 10 mit dem folgenden zusätzlichen Merkmal:
a. Die Vorrichtung ist ein Akkumulator für ein elektrisches Fahrzeug, insbesondere für ein elektrisches Fahrrad.
